# EUROPÄISCHE PATENTSCHRIFT

(11) **EP 4 026 158 B1**
(45) Veröffentlichungstag und Bekanntmachung des Hinweises auf die Patenterteilung: **10.12.2025**
(21) Anmeldenummer: 20756820.5
(22) Anmeldetag: 11.08.2020
(51) Int. Cl.: H01J 37/32, C23C 14/54

(54) **PLASMABEHANDLUNGSANLAGE UND PLASMABEHANDLUNGSVERFAHREN**
PLASMA TREATMENT APPARATUS AND PLASMA TREATMENT PROCESS
APPAREIL DE TRAITEMENT AU PLASMA ET PROCÉDÉ DE TRAITEMENT AU PLASMA

(30) Priorität: 06.09.2019 DE 102019213591
(43) Veröffentlichungstag der Anmeldung: 13.07.2022
(73) Patentinhaber: Singulus Technologies AG, 63796 Kahl am Main (DE)
(72) Erfinder: MAY, Frank, 60326 Frankfurt (DE); CORD, Bernhard, 63755 Alzenau (DE); HÜBNER, Simon, 63500 Seligenstadt (DE); WOHLFART, Peter, 63796 Kahl am Main (DE)
(74) Vertreter: Vossius & Partner Patentanwälte Rechtsanwälte mbB
(86) Internationale Anmeldenummer: PCT/EP2020/072492
(87) Internationale Veröffentlichungsnummer: WO 2021/043542

(56) Entgegenhaltungen:
- EP-A1- 3 104 418
- EP-A2- 1 146 569
- WO-A1-2011/080661
- US-B1- 6 181 069

## Beschreibung

### TECHNISCHES GEBIET

Die Erfindung betrifft Behandlungsanlagen und Plasmabehandlungsverfahren, bei denen ein induktiv gekoppeltes Plasma ("inductively coupled plasma", ICP) mit einer ICP-Quelle angeregt wird. Die Erfindung betrifft insbesondere derartige Anlagen und Verfahren, die eine Beschichtung, ein Ätzen, ein Reinigen oder eine anderweitige Behandlung eines Substrats in einer Durchlauf- oder Batchanlage ermöglichen.

### HINTEGRUND

Behandlungsanlagen zur Behandlung eines Substrats unter Verwendung eines induktiv gekoppelten Plasmas (ICPs) sind bekannt. Eine Behandlung unter Verwendung von ICP-Quellen zur Plasmaanregung bietet verschiedene Vorteile. Beispielsweise stellt eine ICP-Quelle einen H-Modus mit hoher Elektronendichte zur Verfügung, der für eine effiziente Behandlung vorteilhaft ist.

Beispielhafte Anlagen und Plasmaquellen zur Erzeugung eines ICP sind in der WO 2015/036494 A1 EP 1 146 569 A2, US 6 181 069 B1 und in der DE 10 2016 107 400 A1 offenbart. EP 3 104 418 A1 und WO 2011/080661 A1 offenbaren Anlagen zur Erzeugung eines Mikrowellenplasmas.

Herkömmliche Behandlungsanlagen und Verfahren zur Behandlung eines Substrats unter Verwendung eines ICPs weisen immer noch verschiedene Nachteile auf. Beispielsweise kann es schwierig sein, hohe Abscheidungsraten, stabile Arbeitspunkte auch bei vergleichsweise hohen Drücken und/oder eine hohe Homogenität bei Behandlungsvorgängen zu erreichen. Beispielsweise können parasitäre Beschichtungsprozesse bei herkömmlichen Behandlungsanlagen mit einer ICP-Quelle eine signifikante Abscheidung auf Innenflächen einer Behandlungskammer hervorrufen, insbesondere in der Umgebung von Prozessgasaustrittsöffnungen, die zu einem hohen Wartungsaufwand führt und/oder der Abscheidungsrate auf dem Substrat abträglich ist. Herkömmliche Behandlungsanlagen und Verfahren zur Behandlung eines Substrats unter Verwendung eines ICPs können auch Beschränkungen im Hinblick auf ihre Skalierbarkeit aufweisen. Dies gilt insbesondere, falls der Induktor oder die Induktoren der ICP-Quelle parallel zu einer Substratebene gekrümmt sind, wie z.B. in einer planaren Antennenanordnung mit spiralförmigem Induktor.

### KURZE BESCHREIBUNG DER ERFINDUNG

Der Erfindung liegt die Aufgabe zugrunde, eine verbesserte Behandlungsanlagen und ein verbessertes Verfahren zur Behandlung eines Substrats unter Verwendung eines induktiv gekoppelten Plasmas (ICPs) bereitzustellen. Der Erfindung liegt insbesondere die Aufgabe zugrunde, eine Behandlungsanlage und ein Verfahren anzugeben, die bzw. das parasitäre Abscheidungsvorgänge verringert, eine hohe Abscheidungsrate ermöglicht und einen Betrieb der Behandlungsanlage auch bei höheren Drücken in der Prozesskammer sowie mit größerer Substratbreite und Durchsatz ermöglicht.

Erfindungsgemäß werden eine Behandlungsanlage und ein Plasmabehandlungsverfahren mit den in den unabhängigen Ansprüchen angegebenen Merkmalen bereitgestellt. Die abhängigen Ansprüche definieren Ausführungsbeispiele.

Eine erfindungsgemäße Behandlungsanlage weist eine Prozesskammer zur dynamischen oder statischen Behandlung wenigstens eines Substrats auf. Die Behandlungsanlage weist eine induktiv gekoppelte Plasmaquelle (ICP-Quelle) mit einer Längsrichtung auf. Die ICP-Quelle weist wenigstens einen Induktor, der sich entlang der Längsrichtung der ICP-Quelle erstreckt, eine Gaszuführeinrichtung für ein oder mehrere Prozessgase mit wenigstens einer Auslassöffnung, die konfiguriert ist, an mehreren Positionen entlang der Längsrichtung der ICP-Quelle das Prozessgas oder die Prozessgase zuzuführen, und eine in der Prozesskammer angeordnete Gaslenkanordnung auf. Die Gaslenkanordnung erstreckt sich entlang der Längsrichtung der ICP-Quelle und umgibt den wenigstens einen Induktor teilweise.

Bei der erfindungsgemäßen Behandlungsanlage ist eine lineare ICP-Quelle mit einer Gaslenkanordnung versehen, die den wenigstens einen Induktor teilweise umgibt. Dadurch kann eine gerichtete Strömung von Prozessgas mit höherer Geschwindigkeit in Richtung eines Substrats erzeugt werden. Das Risiko parasitärer Abscheidungsprozesse, beispielsweise in einer Umgebung der Prozessgaseinlässe, kann durch die gerichtete Strömung mit hoher Strömungsgeschwindigkeit verringert werden. Bei Verwendung in einer Abscheidungsanlage kann eine hohe Rate der Abscheidung erreicht werden. Die ICP-Quelle ist entlang ihrer Längsrichtung derart skalierbar, dass eine hohe Behandlungshomogenität auch über größere Substratbreiten erzielbar ist.

Jeder Induktor kann jeweils einen rohrförmigen Leiter aufweisen.

Jeder Induktor kann jeweils von einem zylinderförmigen Isolator, beispielsweise einem Quarzglaszylinder, umgeben sein.

Jeder Induktor kann zur Kühlung mit einem Kühlfluid durchströmbar oder umströmbar sein.

Jeder Induktor kann ein linearer Induktor sein.

Die Gaslenkanordnung kann ein oder mehrere Gaslenkbleche aufweisen.

Die Gaslenkanordnung weist eine den wenigstens einen Induktor und die wenigstens eine Auslassöffnung überdeckende Gashaube auf.

Die Gashaube kann einen Auslass aufweisen, dessen Breite B₁ senkrecht zur Längsrichtung der ICP-Quelle maximal 300 mm, insbesondere maximal 200 mm, insbesondere maximal 150 mm, insbesondere maximal 130 mm ist.

Die Gashaube kann an ihrer vom Auslass fernen Oberseite eine weitere Breite B₂ senkrecht zur Längsrichtung der ICP-Quelle aufweist, die kleiner als die Breite B₁ des Auslasses ist.

Die Gashaube kann eine in Höhenrichtung, d.h. der dem Substrat abgewandten Seite, der Gashaube abnehmende lichte Weite aufweist.

Die Gashaube kann eine Höhe H in einer Mittelebene der Gaslenkanordnung und einen Auslass mit einer Breite B₁ senkrecht zur Längsrichtung der ICP-Quelle aufweisen. Ein Verhältnis der Breite B₁ des Auslasses zur Höhe der Gaslenkanordnung, B₁/H, ist kleiner als 1,0, insbesondere kleiner als 0,7, insbesondere kleiner als 0,6, insbesondere kleiner als 0,5 sein.

Durch eine schmale Ausgestaltung der Gashaube in der Richtung quer zur Längsrichtung der ICP-Quelle kann das Risiko parasitärer Abscheidungsprozesse effizient verringert und/oder eine hohe Rate der Abscheidung erreicht werden.

Die Gaszuführeinrichtung kann wenigstens ein Gaszuführrohr aufweisen, das sich parallel zu dem wenigstens einen Induktor in der Gashaube entlang der Längsrichtung der ICP-Quelle erstreckt.

Die Auslassöffnung der Gaszuführeinrichtung und der wenigstens eine Induktor können entlang einer Mittelebene der Gaszuführeinrichtung voneinander beabstandet sein.

Die Auslassöffnung eines Gaszuführrohrs kann oberhalb des wenigstens einen Induktors, d.h. weiter beabstandet vom Auslass der Gashaube positioniert sein.

Der wenigstens eine Induktor kann einen ersten Induktor und einen zweiten Induktor aufweisen.

Der erste Induktor kann mit dem zweiten Induktor elektrisch in Reihe verschaltet sein. Auf diese Weise kann eine Induktorschleife gebildet werden.

Der erste Induktor kann mit dem zweiten Induktor elektrisch parallel verschaltet sein.

Der erste Induktor und der zweite Induktor können in einer Mittelebene der Gaslenkanordnung angeordnet sein.

Durch eine derartige Anordnung mehrerer Induktoren kann die ICP-Quelle mit einer geringen Breite, gemessen senkrecht zur Längsrichtung der ICP-Quelle, ausgeführt werden. Dadurch kann das Risiko parasitärer Abscheidungsprozesse effizient verringert und/oder eine hohe Rate der Abscheidung erreicht werden.

Die ICP-Quelle kann einen Generator aufweisen, der mit dem wenigstens einen Induktor gekoppelt ist.

Der Generator kann elektrisch oder elektromagnetisch mit dem wenigstens einen Induktor verbunden sein.

Die ICP-Quelle kann eine Anpassschaltung aufweisen, die z.B. Spulen und/oder Kondensatoren beinhalten kann, jedoch nicht darauf beschränkt ist. Die Anpassschaltung kann zwischen den Generator und den wenigstens einen Induktor geschaltet sein.

Der Generator kann konfiguriert sein, die ICP-Quelle im H-Modus zu betreiben.

Der Generator kann einen HF-oder RF-Generator aufweisen.

Der Generator kann konfiguriert sein, elektrische Wellen mit einer Wellenlänge von wenigstens 5 m, bevorzugt von wenigstens 10 m in dem wenigstens einen Induktor zu erzeugen.

Durch eine derartige Ausgestaltung der ICP-Quelle kann eine hohe Behandlungshomogenität auch dann erreicht werden, wenn sich die ICP-Quelle in ihrer Längsrichtung über mehr als 1.000 mm erstreckt.

Die ICP-Quelle kann konfiguriert sein, ein Plasma mit einer Elektronendichte von wenigstens 10¹⁶/m³, vorteilhaft von wenigstens 10¹⁷/m³ zu erzeugen.

Die ICP-Quelle kann für einen Betrieb bei einem Druck in der Prozesskammer im Bereich von 0,1 bis 1000 Pa , insbesondere von 0,1 bis 500 Pa, insbesondere von 0,1 Pa bis 250 Pa, insbesondere von 0,1 Pa bis 200 Pa, insbesondere von 1 Pa bis 100 Pa, insbesondere von 10 Pa bis 100 Pa konfiguriert sein.

Die Behandlungsanlage kann einen Gasverteiler für Prozessgas aufweisen, wobei die Gaslenkanordnung eine Abschirmung für den Gasverteiler aufweist.

Die Abschirmung kann einen sich in der Längsrichtung der ICP-Quelle entlang der Gaslenkanordnung erstreckenden Auslassschlitz oder eine Reihe von entlang der Längsrichtung der ICP-Quelle angeordneten Durchlässen aufweisen.

Der Auslassschlitz oder die Durchlässe können eine Weite von maximal 40 mm, insbesondere von maximal 25 mm, insbesondere von maximal 10 mm aufweisen.

Der Gasverteiler kann mehrere Auslassöffnungen mit einem Auslassöffnungsdurchmesser aufweisen, wobei ein Verhältnis des Auslassöffnungsdurchmessers zu einem Durchmesser des Gasverteilers höchstens 0,5, insbesondere höchstens 0,1 sein kann.

Durch die Gaslenkanordnung werden parasitäre Beschichtungen in der unmittelbaren Umgebung der Auslassöffnungen unterdrückt. Die durch die Gaslenkanordnung erzeugte Geschwindigkeit eines Schichtbildnergases wirkt beispielsweise einer Rückdiffusion des angeregten Schichtbildners in Richtung der Auslassöffnungen entgegen, wodurch parasitäre Beschichtungsvorgänge in der unmittelbaren Umgebung der Auslassöffnungen des Gasverteilers verringert werden.

Der wenigstens eine Induktor kann eine Länge von wenigstens 1.000 mm, insbesondere von wenigstens 1.200 mm, insbesondere von wenigstens 1.400 mm entlang der Längsrichtung der ICP-Quelle aufweisen.

Die Behandlungsanlage kann eine Durchlaufanlage zur dynamischen Beschichtung von Substraten sein, in der die Substrate an ICP-Quelle vorbeibewegt werden.

Die Längsrichtung der ICP-Quelle kann sich senkrecht zu einer Transportrichtung des Substrats in der Durchlaufanlage erstrecken.

Die Behandlungsanlage kann zur statischen Behandlung der Substrate mit der ICP-Quelle ausgelegt sein, z.B. eine Batch-Anlage sein.

Die Behandlungsanlage kann eine Beschichtungsanlage sein. Die Beschichtungsanlage kann zur Abscheidung von Aluminiumoxid (AlOx) oder Siliziumnitrid (SiNx) konfiguriert sein, ohne hierauf beschränkt zu sein. Beispielsweise können dielektrische Schichten (Oxide, Nitride, und/oder Oxinitride), intrinsische und dotierte halbleitende Schichten, z.B. a-Si, n-/pdotiertes Si und/oder elektrisch leitfähige Oxide (TCO) abgeschieden werden.

Die Behandlungsanlage kann zum Ätzen des Substrats konfiguriert sein. Dazu kann ein chemisches Ätzen oder ein physikalisches Ätzen mit Vorspannung am Substrat oder an der ICP-Quelle ausgeführt werden.

Die Behandlungsanlage kann zum Reinigen des Substrats konfiguriert sein.

Die Behandlungsanlage kann konfiguriert sein, eine Oberfläche des wenigstens einen Substrats zu oxidieren.

Die Behandlungsanlage kann zur Erzeugung von Oxiden, Nitriden und/oder Oxinitriden konfiguriert sein
Die Behandlungsanlage kann zur Funktionalisierung von Oberflächen konfiguriert sein. Die Behandlungsanlage kann beispielsweise zur Funktionalisierung einer Oberfläche mit Hydroxygruppen konfiguriert sein. Die Behandlungsanlage kann konfiguriert sein, durch Erzeugung eines Plasmas mit Sauerstoff und/oder Wasser OH-Gruppen an der Oberfläche zu erzeugen.

Die Behandlungsanlage kann konfiguriert sein, ein Reinigungsverfahren auszuführen.

Ein erfindungsgemäßes Plasmabehandlungsverfahren zum statischen oder dynamischen Behandeln von Substraten mit einer Behandlungsanlage weist die folgenden Schritte auf: Positionieren wenigstens eines Substrats in einer Prozesskammer der Behandlungsanlage, Anregen eines induktiv gekoppelten Plasmas, ICPs, unter Verwendung einer ICP-Quelle, die wenigstens einen Induktor, der sich entlang einer Längsrichtung der ICP-Quelle erstreckt, eine Gaszuführeinrichtung und eine in der Prozesskammer angeordnete Gaslenkanordnung aufweist, die sich entlang einer Längsrichtung der ICP-Quelle erstreckt und den wenigstens einen Induktor teilweise umgibt, und Zuführen von einem Prozessgas oder mehreren Prozessgasen mit der Gaszuführeinrichtung an mehreren Positionen entlang der Längsrichtung der ICP-Quelle.

Die mit dem erfindungsgemäßen Plasmabehandlungsverfahren erzielten Wirkungen entsprechen den unter Bezugnahme auf die Behandlungsanlage beschriebenen Wirkungen.

Die bei dem Plasmabehandlungsverfahren verwendete Behandlungsanlage kann eine Behandlungsanlage nach einem der hier offenbarten Ausführungsbeispiele sein.

Das Plasmabehandlungsverfahren kann ein Beschichtungsverfahren sein. Dabei kann AlOx oder SiNx abgeschieden werden, ohne dass das Verfahren hierauf beschränkt ist.

Bei dem Plasmabehandlungsverfahren kann eine dynamische Schichtabscheidung mit einer Rate erfolgen, die für eine Abscheidung von SiNx wenigstens 70 nm · m/min beträgt oder für eine Abscheidung von AlOx wenigstens 8 nm · m/min beträgt.

Bei dem Plasmabehandlungsverfahren kann eine Schichtabscheidung mit einer Abweichung von weniger als ± 3%, insbesondere von weniger als ± 2% entlang der Längsrichtung der ICP-Quelle erfolgen.

Das Plasmabehandlungsverfahren kann ein Ätzen des Substrats aufweisen. Dazu kann ein chemisches Ätzen oder ein physikalisches Ätzen mit Vorspannung am Substrat ausgeführt werden.

Das Plasmabehandlungsverfahren kann ein Reinigen oder eine Oberflächenbehandlung (z.B. Oxidation und/oder Funktionalisierung) des Substrats aufweisen.

Das Plasmabehandlungsverfahren kann ein Erzeugen von Oxiden, Nitriden und/oder Oxinitriden aufweisen. Es können intrinsische und dotierte halbleitende Schichten, z.B. a-Si, n-/p-dotiertes Si und/oder elektrisch leitfähige Oxide (TCO) abgeschieden werden.

Durch die erfindungsgemäße Behandlungsanlage und das erfindungsgemäße Behandlungsverfahren können verschiedene Wirkungen und Vorteile erzielt werden.

Beispielsweise wird durch die Verwendung einer ICP-Quelle der Betrieb der ICP-Quelle im H-Modus, d.h. mit hoher Plasmadichte und hoher Leitfähigkeit des Plasmas, ermöglicht, ohne dass zwingend Magnete (Permanentmagnete und/oder Elektromagnete) zur Erzeugung des Plasmaseinschlusses erforderlich sind. Die Abscheidung von Schichten mit hoher Rate und Homogenität wird erleichtert. Durch die Verwendung der Gaslenkanordnung wird die Ausbildung und der Betrieb des H-Modus auch bei hohem Druck und mit hoher Stabilität ausgebildet, wodurch ebenfalls die Abscheiderate erhöht werden kann.

Durch die erfindungsgemäße Ausgestaltung der ICP-Quelle kann durch die im Inneren der Prozesskammer angeordnete Gaslenkanordnung das Plasmavolumen verkleinert werden, wodurch bei gegebener Energieeinkopplung die Elektronendichte erhöht und auch bei höheren Drücken der H-Modus stabil aufrecht erhalten werden kann. Dadurch können hohe und homogene Abscheideraten erzielt werden. Eine quer zur Längsrichtung der ICP-Quelle schmale Ausgestaltung der Gaslenkanordnung erhöht die Gasgeschwindigkeit bei gegebenem Gasdurchsatz in Richtung des Substrats. Diese Strömung des Gases wirkt der Diffusion eines Schichtbildners in den oberen Bereich der ICP-Quelle entgegen. Somit wird ein größeren Anteil des Schichtbildners auf das Substrat gelenkt, wodurch eine hohe Abscheiderate erzielt wird. Parasitäre Abscheidungen im Bereich der ICP-Quelle werden verringert. Dadurch kann die Abscheiderate auf dem Substrat erhöht und der Wartungsaufwand der Behandlungsanlage verringert werden.

### KURZE BESCHREIBUNG DER FIGUREN

Ausführungsbeispiele der Erfindung werden nachfolgend unter Bezugnahme auf die Figuren ausführlich beschrieben, in denen identische Bezugszeichen identische oder ähnliche Elemente bezeichnen.
Figur 1 ist eine schematische Darstellung einer Behandlungsanlage nach einem Ausführungsbeispiel in einer Schnittansicht.
Figur 2 ist eine schematische Darstellung einer ICP-Quelle in einer Schnittansicht, wobei eine Zeichenebene senkrecht zu einer Längsrichtung der ICP-Quelle liegt.
Figur 3 ist eine schematische Darstellung einer ICP-Quelle in einer Schnittansicht, wobei eine Zeichenebene senkrecht zu einer Längsrichtung der ICP-Quelle liegt.
Figur 4 ist eine schematische Darstellung einer ICP-Quelle in einer Schnittansicht, wobei eine Zeichenebene senkrecht zu einer Längsrichtung der ICP-Quelle liegt.
Figur 5 ist eine schematische Darstellung einer Anordnung von Induktoren einer ICP-Quelle in einer Prozesskammer in einer Schnittansicht, wobei eine Zeichenebene parallel zu einer Längsrichtung der ICP-Quelle liegt.
Figur 6 ist eine schematische Darstellung einer ICP-Quelle in einer Schnittansicht, wobei eine Zeichenebene senkrecht zu einer Längsrichtung der ICP-Quelle liegt.
Figuren 7 bis 10 zeigen eine Dichte eines Schichtbildners für ICP-Quellen mit unterschiedlichen Geometrien einer Gaslenkanordnung.
Figuren 11 bis 14 zeigen eine Gasströmungsgeschwindigkeit für ICP-Quellen mit unterschiedlichen Geometrien einer Gaslenkanordnung.

### DETAILLIERTE BESCHREIBUNG VON AUSFÜHRUNGSBEISPIELEN

Während bevorzugte oder vorteilhafte Ausführungsbeispiele unter Bezugnahme auf die Figuren beschrieben werden, können bei weiteren Ausführungsbeispielen zusätzliche oder alternative Ausgestaltungen realisiert werden. Während beispielsweise in den Figuren beispielhaft eine Durchlaufanlage dargestellt ist, können Ausführungsbeispiele auch bei Anlagen zur statischen Behandlung, insbesondere Batch-Anlagen, eingesetzt werden.

Während beispielsweise unter Bezugnahme auf die Figuren Ausführungsbeispielen beispielhaft im Kontext einer Beschichtungsanlage zur Abscheidung einer Schicht auf einem Substrat beschrieben werden, können die Behandlungsanlagen und Behandlungsverfahren nach Ausführungsbeispielen der Erfindung auch zum Ätzen, Reinigen, zur Funktionalisierung oder für andere Behandlungsvorgänge von Substraten eingesetzt werden.

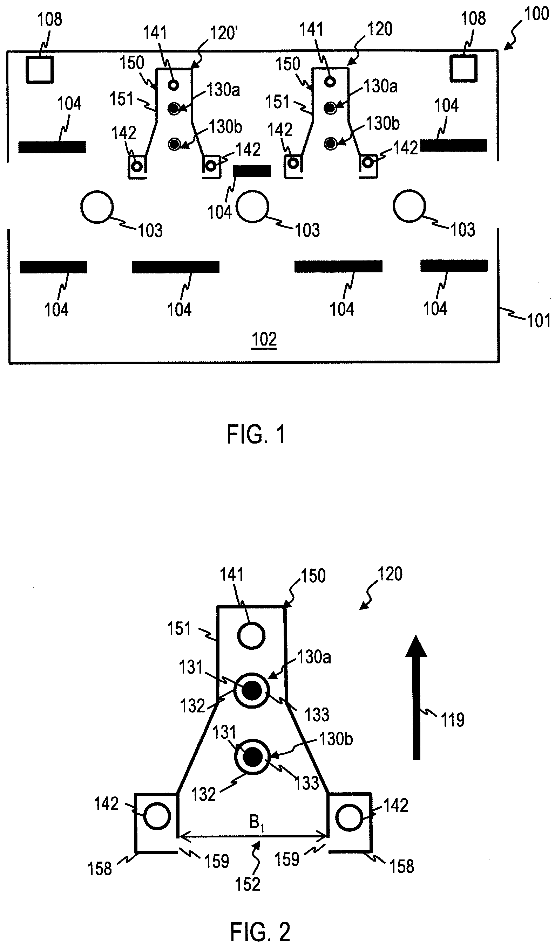

Figur 1 zeigt eine schematische Darstellung einer Behandlungsanlage 100 zum Behandeln von Substraten, insbesondere zum Beschichten, Ätzen, Reinigen und/oder Funktionalisieren von Substraten.

Die Behandlungsanlage 100 weist eine Prozesskammer 101 auf, die einen Prozessraum 102 definiert. Ein oder mehrere Transportwalzen 103 oder andere Transporteinheiten können zum Bewegen eines Substrats vorgesehen sein. Ein oder mehrere Heizeinrichtungen 104 und/oder Blenden 104 können im Prozessraum 102 an einer Seite oder an gegenüberliegenden Seiten einer Substratebene angeordnet sein. Eine Heizeinrichtung 104 oder mehrere Heizeinrichtungen 104 und/oder eine Blende 104 oder mehrere Blenden 104 können beispielsweise gegenüber den nachfolgend noch beschriebenen ICP-Quellen 120, 120' und/oder zwischen den ICP-Quellen 120, 120' angeordnet sein.

Die Behandlungsanlage 100 weist Vakuumpumpen 108 auf, um die Prozesskammer 101 zu evakuieren.

Im Prozessraum 102 ist wenigstens eine ICP-Quelle 120, 120' angeordnet. Während beispielhaft zwei ICP-Quellen 120, 120' dargestellt sind, können bei weiteren Ausführungsbeispielen auch nur eine ICP-Quelle oder mehr als zwei ICP-Quellen im Prozessraum 102 angeordnet sein.

Bei einer als Durchlaufanlage ausgestalteten Behandlungsanlage 100 kann jede ICP-Quelle 120, 120' jeweils so ausgerichtet sein, dass eine Längsrichtung der ICP-Quelle 120, 120' quer, insbesondere senkrecht, zu einer Transportrichtung des Substrats steht.

Eine Ausgestaltung der ICP-Quelle, die bei erfindungsgemäßen Anlagen und Vorrichtungen eingesetzt werden kann, wird nachfolgend detailliert beschrieben. Figuren 2 bis 6 zeigen detailliert mögliche Ausgestaltungen. Wenn die Behandlungsanlage 100 mehrere ICP-Quellen im Prozessraum 102 aufweist, kann eine, mehrere oder alle der ICP-Quellen 120, 120' die hier detailliert beschriebene Ausgestaltung aufweisen.

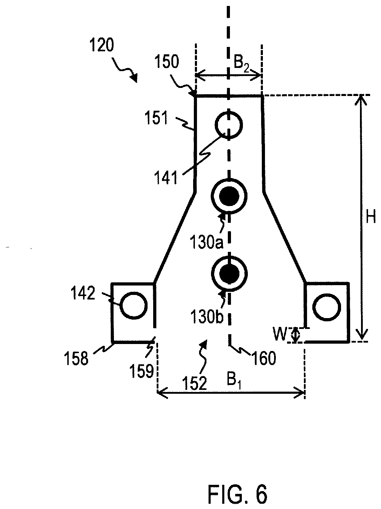

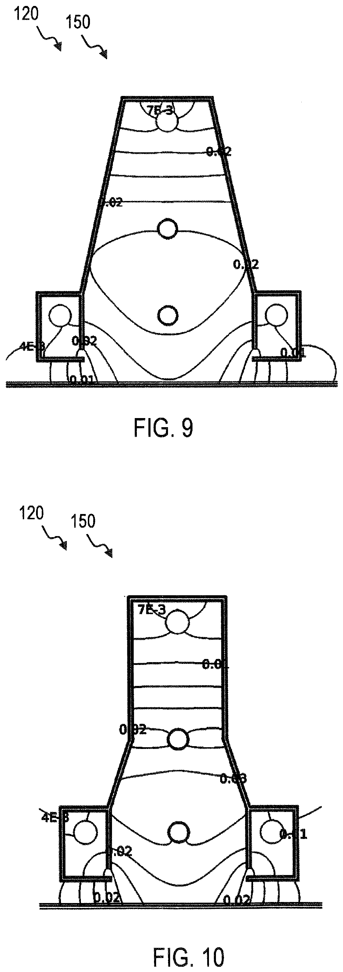

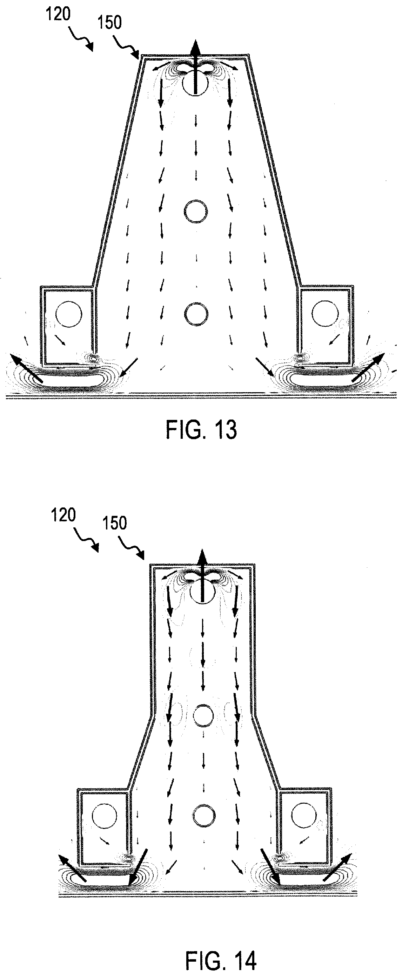

Die ICP-Quelle 120 weist eine Längsrichtung auf. Die Längsrichtung erstreckt sich senkrecht zur Zeichenebene der Figuren 1-5 und 7-14 und parallel zur Zeichenebene der Figur 6. Bei Verwendung in einer Durchlaufanlage kann die Längsrichtung der ICP-Quelle 120 entlang der Breitenrichtung des Substrats, d.h. senkrecht zur Transportrichtung in der Durchlaufanlage gerichtet sein.

Die ICP-Quelle 120 weist wenigstens einen linearen Induktor 130a, 130b auf. Wie in Figuren 1 und 2 dargestellte, kann die ICP-Quelle zwei lineare Induktoren 130a, 130b aufweisen. Die linearen Induktoren 130a, 130b können sich jeweils parallel zueinander und parallel zu einem Gaszuführrohr 141 einer Gaszuführeinrichtung erstrecken.

Die Induktoren 130a, 130b können einen Leiter 131 aufweisen, der rohrförmig ausgebildet sein kann. Die Induktoren 130a, 130b können von einem hohlzylinderförmigen Isolator 132, beispielsweise einem Quarzrohr, umgeben sein. In einem Spalt 133 zwischen dem hohlzylinderförmigen Isolator 132 und dem Leiter 131 und/oder innerhalb des rohrförmigen Leiters 131 kann ein Kühlfluid angeordnet sein, das im Betrieb der Durchlaufanlage den Leiter 131 durchströmt oder umströmt. Das Kühlfluid kann zirkuliert werden.

Die ICP-Quelle weist eine Gaszuführeinrichtung für ein oder mehrere Prozessgase mit wenigstens einer Auslassöffnung auf. Die Gaszuführeinrichtung kann ein Gaszuführrohr 141 aufweisen, das innerhalb einer noch ausführlicher beschriebenen Gashaube 151 angeordnet ist und sich linear parallel zu den Induktoren 130a, 130b erstreckt. Über das Gaszuführrohr 141 kann ein Reaktionsgas oder ein anderes Prozessgas zugeführt werden. Die Gaszuführeinrichtung kann einen Gasverteiler mit ein oder mehreren weiteren Rohren 142 aufweisen, über die beispielsweise ein Precursor zugeführt werden kann.

Die Gaszuführeinrichtung kann konfiguriert sein, an mehreren Positionen entlang der Längsrichtung der ICP-Quelle 120 das Prozessgas oder die Prozessgase zuzuführen. Dazu kann jeweils ein Auslassschlitz und/oder eine Reihe von Auslassöffnungen in dem Gaszuführrohr 141 und in den weiteren Rohren 142 vorgesehen sein.

Erfindungsgemäß weist die ICP-Quelle 120 eine in der Prozesskammer 101 angeordnete Gaslenkanordnung 150 auf. Die Gaslenkanordnung 150 erstreckt sich entlang der Längsrichtung der ICP-Quelle 120. Die Gaslenkanordnung 150 umgibt den wenigstens einen Induktor 130a, 130b und das Gaszuführrohr 141 teilweise, um einen Bereich, in dem Plasma angeregt wird, in einer Richtung quer zur Längsrichtung der ICP-Quelle 120 zu beschränken.

Die Gaslenkanordnung 150 kann ein oder mehrere Bleche aufweisen. Durch die Gaslenkanordnung 150 wird Gas aus dem Bereich um den wenigstens einen Induktor 130a, 130b, durch den Plasma im H-Modus anregbar ist, über einen Auslass 152 der Gaslenkanordnung 150 in Richtung eines Substrats gelenkt. Die Gaslenkanordnung 150 kann in Art von Leitblechen oder Führungsblechen die Strömungsrichtung des Gases definieren und/oder das Plasma in einer Richtung quer zur Längsrichtung des ICP-Quelle räumlich eingrenzen.

Die Gaslenkanordnung 150 weist eine Gashaube auf. Die Gashaube erstreckt sich entlang der Längsrichtung der ICP-Quelle über und teilweise um das Gaszuführrohr 141 und den wenigstens einen Induktor 130a, 130b. Die Gashaube 151 kann eine in Höhenrichtung 119 der Gashaube 151, d.h. von ihrem Auslass 152 in Richtung ihres benachbart zum Gaszuführrohr 141 angeordneten geschlossenen oberen Endes abnehmende lichte Weite aufweisen. Eine Breite B₁ des Auslasses kann klein sein, gemäß der Erfindung kleiner als eine Höhe der Gaslenkanordnung 150. Durch eine derartige schmale Ausgestaltung der Gaslenkanordnung 150 kann effizient eine Strömung in Richtung des Substrats definiert und/oder die Anregung im H-Modus erleichtert werden.

Die Gaslenkanordnung 150 kann ein oder mehrere Abschirmungen 158 aufweisen. Die Abschirmungen 158 können sich entlang der Längsrichtung der ICP-Quelle erstrecken. Die Abschirmungen 158 können außen an der Gashaube 151 vorgesehen sein, um die weiteren Rohre 142 der Gaszuführeinrichtung zu umgeben und eine Strömung von aus den weiteren Rohren 142 austretendem Precursor ins Innere der Gashaube 151 zu unterdrücken. Ein Auslassschlitz oder Durchbrüche 159 der Abschirmungen 158 können das aus den weiteren Rohren 142 austretende Prozessgas in die Nähe des Auslasses 152 führen, wo eine verhältnismä-ßig große Strömungsgeschwindigkeit innerhalb der Gaslenkanordnung 150 eine Diffusion dieses Prozessgases zu den Induktoren 130a, 130b und dem Gaszuführrohr 141 verringert. Der Auslassschlitz 159 kann ein durchgehender Schlitz parallel zur Längsrichtung der ICP-Quelle 120 sein oder kann eine Reihe von Öffnungen oder Durchbrüchen entlang der Längsrichtung der ICP-Quelle 120 aufweisen.

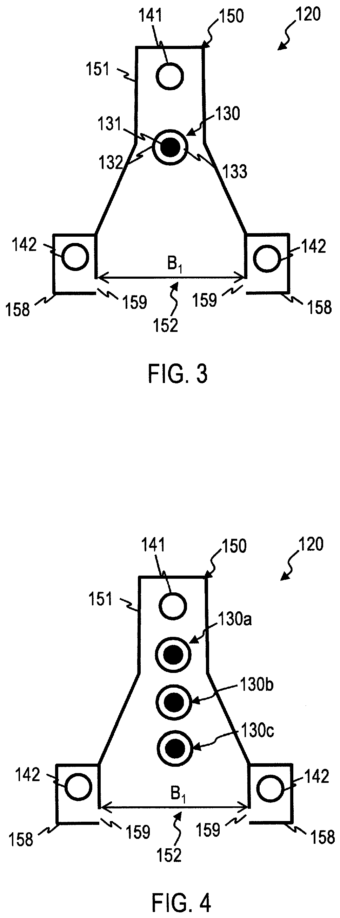

Figur 3 zeigt eine Ausgestaltung der ICP-Quelle 120, bei der nur ein linearer Induktor 130 in der Gashaube 151 der Gaslenkanordnung 150 angeordnet ist. Der Induktor 130 kann einen Leiter 131 aufweisen, der rohrförmig ausgebildet sein kann. Der Induktor 130 kann von einem hohlzylinderförmigen Isolator 132, beispielsweise einem Quarzrohr, umgeben sein. In einem Spalt 133 zwischen dem hohlzylinderförmigen Isolator 132 und dem Leiter 131 und/oder innerhalb des rohrförmigen Leiters 131 kann ein Kühlfluid angeordnet sein, das im Betrieb der Durchlaufanlage den Leiter 131 durchströmt oder umströmt. Das Kühlfluid kann zirkuliert werden. Im Spalt 133 können Gase oder Luft als Kühlfluid verwendet werden. Der rohrförmige Leiter 131 kann mit flüssigen Medien, beispielsweise Wasser, gekühlt werden.

Figur 4 zeigt eine Ausgestaltung der ICP-Quelle 120, bei der drei linearer Induktoren 130a, 130b, 130c in der Gashaube 151 der Gaslenkanordnung 150 angeordnet ist. Die Induktoren 130a, 130b, 130c können einen Leiter 131 aufweisen, der rohrförmig ausgebildet sein kann. Die Induktoren 130a, 130b, 130c können von einem hohlzylinderförmigen Isolator 132, beispielsweise einem Quarzrohr, umgeben sein. In einem Spalt 133 zwischen dem hohlzylinderförmigen Isolator 132 und dem Leiter 131 und/oder innerhalb des rohrförmigen Leiters 131 kann ein Kühlfluid angeordnet sein, das im Betrieb der Durchlaufanlage den Leiter 131 durchströmt oder umströmt. Das Kühlfluid kann zirkuliert werden.

Wenn zwei Induktoren 130a, 130b oder mehr als zwei Induktoren 130a, 130b, 130c in der Gashaube 151 der Gaslenkanordnung 150 angeordnet sind, sind die Induktoren 130a, 130b, 130c vorteilhaft in einer Mittelebene der ICP-Quelle 120 angeordnet.

Die Mittelebene kann eine Symmetrieebene der ICP-Quelle 120 sein, die sich parallel zur Längsrichtung der ICP-Quelle 120 erstreckt.

Alternativ oder zusätzlich kann die Mittelebene 160 der ICP-Quelle 120 derart definiert sein, dass sie durch eine Mittellinie des Auslasses 152 der Gaslenkanordnung 150 der ICP-Quelle 120 und durch eine Mittellinie des vom Auslass 152 beabstandeten und zum Gaszuführrohr 141 benachbarten oberen Endes der Gaslenkanordnung 150 der ICP-Quelle 120 verläuft.

Alternativ oder zusätzlich kann die Mittelebene 160 der ICP-Quelle 120 durch einen mittleren Geschwindigkeitsvektor des von der ICP-Quelle 120 am Auslass 152 austretenden Gases definiert sein, wobei die Mittelung über die Fläche des Auslasses 152 erfolgen kann.

Alternativ oder zusätzlich kann die Mittelebene 160 der ICP-Quelle 120 senkrecht zu einer Substratebene stehen.

Alternativ oder zusätzlich kann die Mittelebene 160 der ICP-Quelle 120 eine Mittellinie des Gaszuführrohrs 141 und wenigstens eines, bevorzugt aller, Induktoren 130, 130a-c enthalten.

Wenn zwei Induktoren 130a, 130b oder mehr als zwei Induktoren 130a, 130b, 130c in der Gashaube 151 der Gaslenkanordnung 150 angeordnet sind, können die zwei Induktoren 130a, 130b oder mehr als zwei Induktoren 130a, 130b, 130c elektrisch in Reihe oder parallel verschaltet sein.

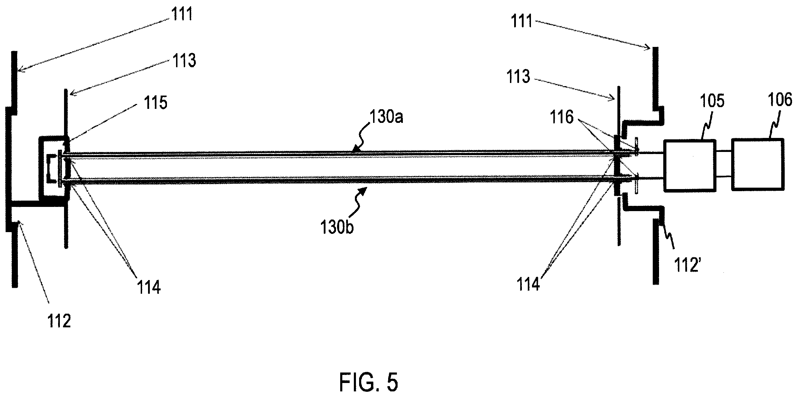

Figur 5 zeigt eine Schnittansicht von Induktoren 130a, 130b einer ICP-Quelle. Die Gaslenkanordnung 150 ist nicht dargestellt.

Die Induktoren 130a, 130b können über eine Kopplungseinheit 115 elektrisch und/oder fluidisch miteinander verbunden werden. Die Kopplungseinheit 115 kann eine elektrische Verbindung zwischen den Induktoren 130a, 130b herstellen, um diese in Reihe zu verschalten, und/oder mit Masse zu koppeln. Die Kopplungseinheit 115 kann eine fluidische Verbindung zwischen den Induktoren 130a, 130b herstellen, die es erlauben, Kühlfluid sequentiell durch oder über den ersten Induktor 130a und dann durch oder über den zweiten Induktor 130b zu leiten. Eine Einkopplung von Kühlflüssigkeit und/oder eine Einkopplung von elektrischer Energie kann über Anschlüsse 116 erfolgen.

Abschirmungen 113 können an gegenüberliegenden Enden der Induktoren 130a, 130b zum Abschluss der Gaslenkanordnung 150 in Längsrichtung vorgesehen sein. Die Induktoren 130a, 130b können über Dichtungen 114, beispielsweise über Quetschdichtungen, an den Abschirmungen 113 angebracht sein. Die Dichtungen 114 erlauben es, die Induktoren 130 a, 130b über Flansche 112, 112' vakuumdicht mit den Wänden 111 der Prozesskammer 102 zu verbinden.

Wände 111 der Prozesskammer 102 können so ausgestaltet sein, dass sie einen beidseitigen Einbau der ICP-Quelle 120 ermöglichen. Beispielsweise können die Wände 111 eine symmetrische Öffnung an gegenüberliegenden Seiten aufweisen, um einen Einbau der Induktoren 130a, 130b mittels der Flansche 112, 112' von beiden Seiten der Prozesskammer 102 zu erlauben.

Die ICP-Quelle 120 weist einen schematisch dargestellten Generator 106 auf, der ein Hochfrequenz (HF)- oder Radiofrequenz (RF)-Generator sein kann. Der HF- oder RF-Generator 106 kann, beispielsweise über eine Anpassschaltung 105, elektrisch oder elektromagnetisch mit den Induktoren 130a, 130b verbunden sein. Der HF-oder RF-Generator 106 kann konfiguriert sein, elektrische Wellen mit einer Wellenlänge von wenigstens 5 m, bevorzugt von wenigstens 10 m in dem wenigstens einen Induktor 130a, 130b zu erzeugen. Durch eine derartige Ausgestaltung kann eine hohe Behandlungshomogenität auch dann erreicht werden, wenn sich die ICP-Quelle in ihrer Längsrichtung über mehr als 1.000 mm erstreckt.

Der HF-oder RF-Generator 106 kann konfiguriert sein, ein Plasma mit einer Elektronendichte von wenigstens 10¹⁶/m³, vorteilhaft von wenigstens 10¹⁷/m³ zu erzeugen.

Figur 6 zeigt eine Geometrie der Gaslenkanordnung 150, die bei Ausführungsbeispielen verwendet werden kann. Während beispielhaft zwei Induktoren 130a, 130b dargestellt sind, kann die Geometrie auch bei einer ICP-Quelle mit nur einem Induktor oder mit mehr als zwei Induktoren in der Gaslenkanordnung verwendet werden.

Die Gaslenkanordnung 150 weist eine Gashaube 151 mit einem Auslass 152 auf. Das Gaszuführrohr 141 und der wenigstens eine Induktor 130a, 130b sind in der Gashaube 151 angeordnet. Das Gaszuführrohr 141 und der wenigstens eine Induktor 130a, 130b können an einer Mittelebene 160 der ICP-Quelle 120 positioniert sein.

Die Gaslenkanordnung 150 weist eine Höhe H in der Mittelebene 160 der Gaslenkanordnung auf. Der Auslass 152 weist eine Breite B₁ senkrecht zur Längsrichtung der ICP-Quelle 120 auf. Ein Verhältnis der Breite B₁ des Auslasses 152 zur Höhe H, B₁/H, ist kleiner als 1,0. Weiter vorteilhaft ist das Verhältnis der Breite B₁ des Auslasses 152 zur Höhe H, B₁/H, kleiner als 0,7, insbesondere kleiner als 0,6, insbesondere kleiner als 0,5.

Bei einer beispielhaften Ausgestaltung ist die Breite B₁ des Auslasses 152 senkrecht zur Längsrichtung der ICP-Quelle maximal 300 mm, insbesondere maximal 200 mm, insbesondere maximal 150 mm, insbesondere maximal 130 mm.

Die Gaslenkanordnung 150 weist eine Oberseite fern vom Auslass 152 auf, die eine Breite B₂ quer zur Längsrichtung der ICP-Quelle 120 aufweist. Die Breite B₂ ist kleiner als die Breite B₁ des Auslasses 152. Vorteilhaft ist B₂/B₁ kleiner als 1, insbesondere kleiner als 0,9, insbesondere kleiner als 0,8.

Eine lichte Weite der Gashaube 151 kann vom Auslass 152 bis zur vom Auslass 152 fernen Oberseite abnehmen, insbesondere monoton (aber nicht notwendig streng monoton) abnehmen.

Der Schlitz 159 oder jede der Öffnungen 159 der Abschirmung 158 kann eine Weite W aufweisen, die bei beispielhaften Ausgestaltungen maximal 40 mm, insbesondere maximal 25 mm, insbesondere maximal 10 mm betragen kann.

Der Induktor 130 oder alle Induktoren 130a, 130b, 130c, die Gaslenkanordnung 150 und die Rohre 141, 142 der Gaszuführeinrichtung können sich linear über eine Länge von wenigstens 1.000 mm, insbesondere von wenigstens 1.200 mm, insbesondere von wenigstens 1.400 mm entlang der Längsrichtung der ICP-Quelle 120 erstrecken.

Der Induktor 130 oder alle Induktoren 130a, 130b, 130c können beispielsweise als koaxiale Anordnung von einem Kupferrohr als Innenleiter 131 ausgeführt sein, welches sich in einem Quarzglasrohr 132 befindet. Das Kupferrohr kann zur Kühlung mit Kühlmittel (z.B. Wasser) durchströmt werden. Das Kupferrohr kann mit einer isolierenden Keramik ummantelt sein. Dies hat den Vorteil, dass die Isolation sehr dünn sein kann, beispielsweise 0,1 bis 2 mm Dicke aufweisen kann, und/oder dass kein Luftspalt vorhanden sein muss. Dadurch wird ein Verhältnis der Radien von Isolator 132 und Innenleiter 131 gering.

Wird das Plasma zum koaxialen Außenleiter in dieser Anordnung, was insbesondere im ICP-H-Modus auftritt, bewirkt die Verringerung des Radienverhältnisses von Außenrohr 132 zu Innenleiter 131, dass die Reaktanz bzw. Impedanz der Quelle verringert wird, wodurch sich bei gleicher eingekoppelter Leistung die Ströme erhöhen und die Spannungen verringern. Dies erhöht bei einem stromgetriebenen ICP die Effizienz der Einkopplung.

Weiterhin besteht die Möglichkeit, dass durch Variation des Kupferrohrradius, z.B. durch Abdrehen, entlang der Längsrichtung der ICP-Quelle 120 und/oder durch Variation der Isolationsdicke die Quellenimpedanz entlang der Längsrichtung der ICP-Quelle 120 veränderlich gestaltet werden kann. Dadurch kann die Inhomogenität der Plasmadichte entlang der Längsrichtung der ICP-Quelle 120, wie sie z.B. an den beiden Enden ICP-Quelle auftreten, teilweise oder vollständig kompensiert werden. Der Induktor 130 oder die mehreren Induktoren 130a, 130b, 130c können hierfür so ausgestaltet werden, dass jeweils die Impedanz von den Enden der Induktoren zu deren Mitte hin abnimmt.

Die Einkopplung der Leistung in mehrere Induktoren 130a, 130b einer ICP-Quelle 130 kann verschieden ausgeführt werden:
a) Die Induktoren 130a, 130b können elektrisch in Reihe verschaltet sein. Die Verbindung der Leiter der Induktoren 130a, 130b zur Schlaufe erfolgt in der Kopplungseinheit 115. Diese Kopplungseinheit kann als geschlossener Hohlraum ausgebildet werden, in dem bevorzugt atmosphärischer Druck herrscht. Die Leistung wird vom HF-oder RF-Generator 106 an der zur Kopplungseinheit 115 gegenüberliegenden Seite an nur einen der Induktoren bereitgestellt. Die Leistung kann in einen der Induktoren 130a oder 130b eingekoppelt werden. Der andere Induktor kann direkt oder über passive elektronische Bauelemente mit Masse verbunden sein. Alternativ besteht die Möglichkeit eines offenen Endes.
b) Die Induktoren 130a, 130b können parallel betrieben werden. Die Leiter der Induktoren 130a, 130b sind auf der Einkoppelseite verbunden. Die Leistung wird vom HF-oder RF-Generator 106 an der zur Kopplungseinheit 115 gegenüberliegenden Seite an beide Induktoren 130a, 130b bereitgestellt. In der Kopplungseinheit 115 können die Leiter geerdet sein. Alternativ können die Leiter über passive elektronische Bauelemente geerdet oder jeweils über eigene passive elektronische Bauelemente geerdet sein, wobei die passiven Bauelemente gleiche oder unterschiedliche Impedanz aufweisen können. Die Leiter können in der Kopplungseinheit 115 nicht verbunden und nicht geerdet sein (offenes Ende).
c) Die Einkopplung in die Induktoren 130a, 130b kann gegenläufig erfolgen. Hierfür muss ein zusätzlicher Leiter, isoliert von der restlichen Anordnung und vom Plasma, zur Kopplungseinheit 115 geführt werden. Die Induktoren können dann unabhängig entweder mit Masse verbunden, oder über passive elektronische Bauelemente mit Masse verbunden, oder offen sein.
d) Nur einer der Induktoren 130a, 130b wird betrieben. Die Leistung wird vom HF-oder RF-Generator 106 an der zur Kopplungseinheit 115 gegenüberliegenden Seite an nur einen der Induktoren bereitgestellt. In der Kopplungseinheit 115 ist der Leiter entweder mit Masse verbunden, oder über passive elektronische Bauelemente mit Masse verbunden, oder offen.

Die ICP-Quelle 120 kann so ausgestaltet sein, dass über die Gaszuführeinrichtung zwei unterschiedliche Prozessgase oder Prozessgasgemische zuführbar sind. Die Strömung der unterschiedlichen Prozessgase oder Prozessgasgemische kann unabhängig voneinander einstellbar sein.

Über das Gaszuführrohr 141 kann ein erstes Prozessgas oder ein erstes Prozessgasgemisch zugeführt werden.

Über die weiteren Rohre 142 kann ein zweites Prozessgas, das von dem ersten Prozessgas verschieden ist, oder ein zweites Prozessgasgemisch zugeführt werden, das von dem ersten Prozessgasgemisch verschieden ist.

Die Rohre 141, 142 sind zur Zuführung der Prozessgase oder Prozessgasgemische mit Gasauslassbohrungen versehen. Die Gasauslassbohrungen können in beliebigen Abständen und Durchmessern angeordnet sein können. Zur besseren Gasdurchmischung und zum Schutz vor einem Verschluss durch parasitäre Beschichtungen können sich diese Gasauslassbohrungen an von der Substratebene abgewandten Seite und/oder an der vom Auslass 152 abgewandten Seite der Rohre 141, 142 befinden.

Die Rohre 141, 142 können entlang der Längsrichtung der ICP-Quelle 120 gasdicht unterbrochen, d.h. segmentiert sein. Die Behandlungsanlage kann konfiguriert sein, die einzelnen Segmente mit unabhängigem Gasfluss zu beaufschlagen. Eine Summe der Querschnitte aller Gasauslassbohrungen ist pro Segment vorteilhaft mindestens um einen Faktor 3 kleiner ist als die Querschnittsfläche 141, 142 des entsprechenden Rohrs 141, 142. Dadurch kann gewährleistet werden, dass der Gasfluss einer Gasauslassbohrung proportional zu deren Querschnittsfläche ist und definierte Strömungen im Prozessraum 102 erzeugt werden. Die Gasauslassbohrungen und der Gasfluss sind so gewählt, dass sich die Gasgeschwindigkeit nicht der Schallgeschwindigkeit annähert, um nichtlineares Verhalten zu unterbinden.

Die ICP-Quelle 120 kann so konfiguriert sein, dass eine maximale Elektronendichte im erzeugten Plasma 10¹⁴ bis 10²¹/m³, insbesondere 10¹⁴ bis 10²⁰/m³, insbesondere 10¹⁴ bis 10¹⁹/m³ beträgt. Die maximale Elektronendichte im erzeugten Plasma kann wenigstens 10¹⁶/m³, vorteilhaft wenigstens 10¹⁷/m³ betragen.

Die ICP-Quelle 120 kann so konfiguriert sein, dass eine Gasgeschwindigkeit in der Mitte des Auslasses 152 von 0,01 bis 100 m/s, insbesondere 0,01 bis 50 m/s, insbesondere 0,01 bis 10 m/s beträgt.

Die ICP-Quelle 120 kann so konfiguriert sein, dass eine Plasmaleistung pro Länge der ICP-Quelle 0,1 bis 100 kW/m, insbesondere 0,1 bis 50 kW/m, insbesondere 0,1 bis 10 kW/m beträgt.

Die ICP-Quelle 120 ist für einen Betrieb in einem Prozessraum mit einem Druck im Prozessraum von 0,1 bis 1000 Pa, insbesondere von 0,1 bis 500 Pa, insbesondere von 0,1 bis 250 Pa, insbesondere von 0,1 bis 200 Pa, insbesondere von 1 Pa bis 100 Pa, insbesondere von 10 Pa bis 100 Pa ausgelegt. Der Druck im Prozessraum kann jeweils an einer Auslassöffnung des Prozessgases im Inneren des Prozessraums ermittelt werden.

Wenn die Behandlungsanlage 100 als Beschichtungsanlage ausgestaltet ist, kann die Behandlungsanlage für eine Abscheidung mit einer dynamischen Abscheiderate von 0 bis 1000 nm · m/min, insbesondere von 0 bis 500 nm · m/min, insbesondere von 0 bis 200 nm · m/min ausgelegt sein. Diese Abscheideraten sind die in der Behandlungsanlage 100, die mehrere ICP-Quellen aufweisen kann, erzielten Abscheideraten.

Bei Verwendung in einem Prozessraum mit einem Druck von 0,1 bis 1000 Pa, insbesondere von 0,1 bis 500 Pa, insbesondere von 0,1 bis 250 Pa, insbesondere von 0,1 bis 200 Pa, insbesondere von 1 Pa bis 100 Pa, insbesondere von 10 Pa bis 100 Pa wird die Gasströmung relevant für die Prozessführung. Anders als bei dem geringeren Druck in PVD-Anlagen werden bei steigendem Druck Transportphänomene gegenüber der Diffusion relevanter. Der hohe Reaktivgasstrom in Substratrichtung minimiert die Diffusion des Precursorgases in die Gegenrichtung dieser Strömung. Dadurch wird die Abscheidung auf dem Substrat begünstigt und gleichzeitig das ungewollte Beschichten der restlichen Komponenten der ICP-Quelle 120, wie der Induktoren 130, 130a-c und/oder der Rohre 141, 142 verringert. Durch eine zu schmale Ausgestaltung der Gaslenkanordnung 150 kann eine gute Abscheiderate der Quelle bei verringerter parasitärer Beschichtung der ICP-Quelle 120 am Gaszuführrohr 141 und dem wenigstens einen Induktor 130, 130a-c erreicht werden.

Mit der ICP-Quelle 120, 120' können dielektrische Schichten (Oxide, Nitride, und/oder Oxinitride), intrinsische und dotierte halbleitende Schichten, z.B. a-Si, n-/p-dotiertes Si und/oder elektrisch leitfähige Oxide (TCO) abgeschieden werden.

Die Behandlungsanlage 100 kann alternativ oder zusätzlich zum Ätzen, Reinigen, Funktionalisieren oder für eine anderweitige Behandlung von Substraten ausgelegt sein.

Beispielsweise kann unter Verwendung von elektronegativen Gasen (z.B. F₂, NF₃, Cl₂, O₂) und/oder Wasserstoff als Prozessgas die ICP-Quelle 120, 120' zum chemischen Ätzen von Substraten z.B. Silizium, Glas, Kunststoff, Metall und Schichten aus Kohlenstoff oder dielektrischen Materialien (z.B. Siliziumoxid) verwendet werden. Alternativ kann in Kombination mit einer Vorspannung am Substrat oder der ICP-Quelle 120, 120' die ICP-Quelle 120, 120' zum physikalischen Ätzen von Substraten und Oberflächen genutzt werden.

Bei weiteren Ausführungsformen ist die Oxidation, Erzeugung von Nitriden oder Oxinitriden bei metallischen oder halbleitenden Substraten oder Beschichtungen mit der ICP-Quelle 120, 120' möglich. Hierfür können Prozessgase verwendet werden, die Sauerstoff, Stickstoff oder Verbindungen, die Sauerstoff und/oder Stickstoff enthalten, aufweisen. Unter Verwendung der der ICP-Quelle 120, 120' können beispielsweise Tunneloxidschichten (z.B. Siliziumoxid) auf Substraten abgeschieden werden.

Die Behandlungsanlage 100 kann konfiguriert sein, durch Erzeugung eines Plasmas mit Sauerstoff und/oder Wasser OH-Gruppen an einer Oberfläche zu erzeugen, um die Oberfläche zu funktionalisieren. Auf diese Weise kann eine Funktionalisierung der Oberfläche mit Hydroxygruppen erfolgen.

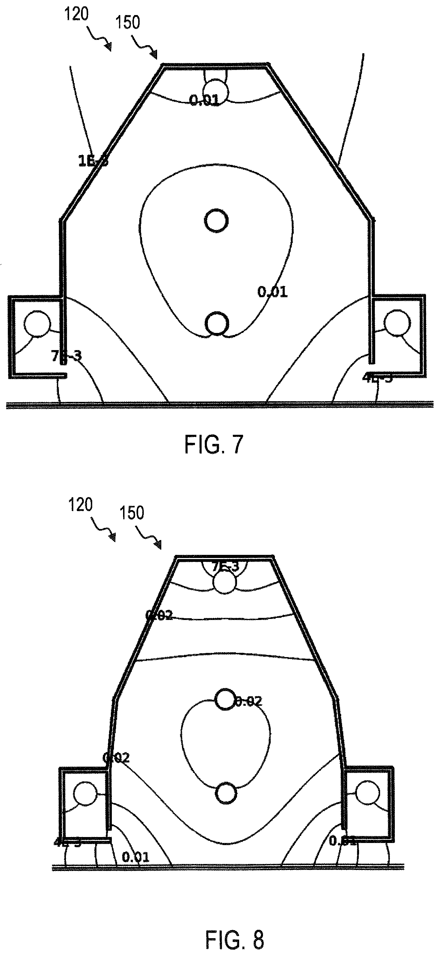

Figur 7 bis Figur 10 zeigen beispielhaft den Einfluss der Breite der Gaslenkanordnung 150 auf eine Konzentration von SiH₃ bei Zuführung von SiH₄. Dabei sind Linie gleicher Konzentration von SiH₃ mit Höhenlinien unter Angabe der Konzentration (in beliebigen Einheiten, wobei in Figuren 7 bis 10 zueinander konsistente Einheiten verwendet sind) dargestellt. Bei schmalerer Ausgestaltung der Gaslenkanordnung, beispielsweise bei einem geringeren Verhältnis der Breite B₁ des Auslasses 152 zur Höhe H, B₁/H, kann nicht nur die Konzentration von SiH₃ erhöht werden, sondern das Konzentrationsmaximum entlang der Höhenrichtung 119 der ICP-Quelle 120 nach unten hin zum Auslass 152 verschoben werden. Dies verringert parasitäre Beschichtungen in der ICP-Quelle 120 und erhöht die Abscheiderate am Substrat.

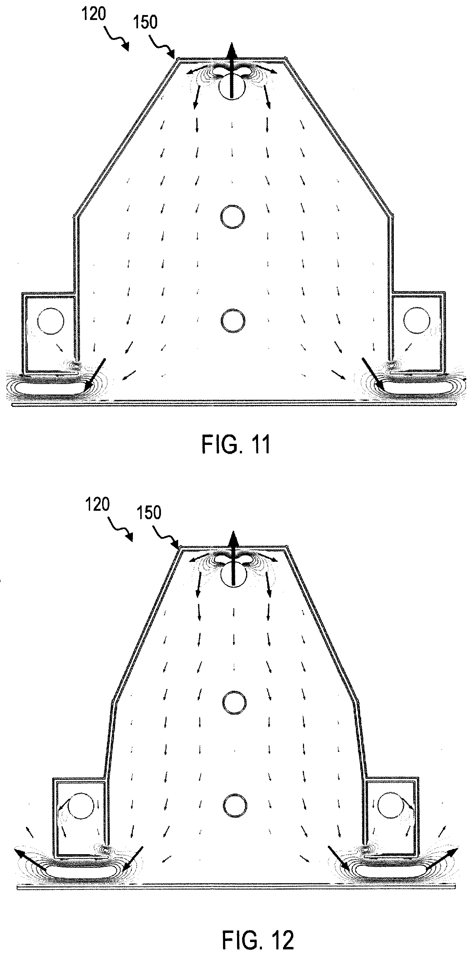

Figur 11 bis Figur 14 zeigen beispielhaft den Einfluss der Breite der Gaslenkanordnung 150 auf eine Strömungsgeschwindigkeit des Gases. Die Strömungsrichtung ist als Vektorfeld dargestellt, wobei die Länge der Vektoren jeweils den Betrag der Geschwindigkeit repräsentiert. Linien mit gleichem Geschwindigkeitsbetrag sind zusätzlich als Höhenlinien dargestellt. Bei schmalerer Ausgestaltung der Gaslenkanordnung, beispielsweise bei einem geringeren Verhältnis der Breite B₁ des Auslasses 152 zur Höhe H, B₁/H, können am Auslass 152 höhere Geschwindigkeiten in Richtung des Substrats erreicht werden. Dies verringert parasitäre Beschichtungen in der ICP-Quelle 120, indem eine Diffusion in Richtung des Rohrs 141 und der Induktoren 130a, 130b verringert wird, und erhöht die Abscheiderate am Substrat.

Verschiedene Vorteile und Wirkungen können durch eine Behandlungsanlage und ein Behandlungsverfahren mit der ICP-Quelle 120 erreicht werden.

Bei Verwendung in einer Beschichtungsanlage ermöglicht die ICP-Quelle eine hohe Abscheiderate. Diese kann für eine Abscheidung von SiNx wenigstens 70 nm · m/min betragen oder für eine Abscheidung von AlOx wenigstens 8 nm · m/min betragen.

Für die Abscheidung von Schichten bestimmter Dicke können bei vorgegebenem Durchsatz in einer Anlage weniger Quellen verwendet werden und/oder bei vorgegebener Zahl der Beschichtungsquellen kann der mögliche Durchsatz einer Beschichtungsanlage erhöht werden. Das Problem hoher Anlagenkosten kann somit verringert werden.

Stabile Arbeitspunkte werden auch bei höheren Drücken im Prozessraum möglich. Mit dem Prozessgasdruck steigt typischerweise der erreichbare Stoffmengendurchsatz einer Vakuumpumpe und somit auch der erreichbare Stoffmengendurchsatz eines Prozesses, welcher die Abscheiderate limitiert. Bei einem vorgegebenen Stoffmengendurchsatz eines Prozesses können bei höheren Drücken Pumpen mit geringerer Leistung verwendet werden, oder bei Verwendung von Pumpen mit vorgegebenem Leistung können höhere Stoffmengendurchsätze und somit Abscheideraten erreicht werden. Das Problem hoher Anlagenkosten kann somit verringert werden.

Es kann eine homogene Schichtabscheidung erreicht werden. Die Homogenität kann im Hinblick auf die Abscheiderate und/oder die Schichteigenschaften in Längsrichtung der ICP-Quelle erreicht werden. Dies erlaubt die Behandlung breiterer Substrate oder eine gleichzeitige Behandlung einer größeren Anzahl von kleinen Substraten. Anlagenkosten können so verringert und/oder der Durchsatz erhöht werden.

Der Wartungsaufwand kann aufgrund einer Unterdrückung von parasitärer Beschichtung an Prozessgasaustrittsöffnungen und einer hohen Abscheidung auf dem Substrat verringert werden. Probleme aufgrund intensiver PECVD- typischer Wartungsarbeiten werden reduziert.

Eine prozessspezifische Reaktivgasführung wird erleichtert. Dies ist insbesondere für AlOx-Prozesse vorteilhaft. Durch die prozessspezifische Reaktivgasführung kann die Reaktivität des angeregten Prozessgases bedarfsgerecht herabgesetzt werden. Zum Erreichen einer geringen Reaktivität des angeregten Reaktivgases sollte die eingekoppelte Plasmaleistung nicht unterhalb der zur Aufrechterhaltung des H-Mode nötigen Grenze abgesenkt werden. Der dominierende Prozess der Energieeinkopplung bleibt die elektromagnetische Induktion. Aufgrund des konstanten elektrischen Stromes in der Induktorschleife können homogene Plasmabedingungen in Quellenlängsrichtung erhalten werden.

Das Problem einer zu hohen Reaktivität des Reaktivgases, welches parasitäre Abscheidungen in der ICP-Quelle verstärkt und somit die Abscheiderate verringert, kann somit ebenfalls reduziert werden.

Die ICP-Quelle ist in Quellenlängsrichtung skalierbar. Quellenlängen von mehr als 1.000 mm, insbesondere von mehr als 1.400 mm können bei immer noch guter Homogenität der Behandlung realisiert werden. Dies erlaubt größere Beschichtungsbreiten unter Beibehaltung der Homogenität. Der Durchsatz der Beschichtungsanlage kann erhöht werden, und/oder bei vorgegebenem Durchsatz kann die Quellenanzahl verringert werden.

Die Prozessraumbegrenzung vom Reaktivgaseinlass am Gaszuführrohr 141 bis zum Precursoreinlass an der Öffnung 159 umschließt die Induktoren 130, 130a-c quer zur Längsrichtung der ICP-Quelle und begrenzt somit den Plasmaraum. Die Gaslenkanordnung 150 kann aufgrund der Anordnung der Induktoren 130a, 130b entlang der Mittelebene 160 der ICP-Quelle schmal im Vergleich zu einer parallelen Induktorschleifenanordnung ausgeführt werden. Das Plasmavolumen wird verkleinert, wodurch sich bei einer gegebenen Energieeinkopplung die Plasmadichte und dadurch die Leitwert des Plasmas erhöhen. Die Entladung im H-Modus kann so auch bei höheren Drücken erfolgen.

Des Weiteren führt eine schmale Ausgestaltung der Gaslenkanordnung 150 quer zur Längsrichtung der ICP-Quelle bei einem gegebenen Stoffmengendurchsatz des Reaktivgases zur Erhöhung der mittleren Gasgeschwindigkeit in Richtung des Substrates. Der diffusionsgetriebene Transport des Precursorgases von den entsprechenden Gaseinlässen in der Nähe der Substratebene in Richtung des wenigstens einen Induktors wird reduziert. Die Abschirmung 158, welche die Gasauslassöffnungen in den weiteren Gasrohren 142 für das Precursorgas umgibt, verhindert, dass angeregtes Reaktivgas ins Innere der Abschirmungen 158 diffundiert. Parasitäre Beschichtungen in diesem Bereich werden vermieden, so dass das Risiko eines Verschlusses der Gasauslassöffnungen in den weiteren Gasrohren 142 verringert wird.

Der Gasaustrittsspalt 159 oder die Öffnungen 159 dieser Abschirmung 158 können nah zum Substrat angeordnet sein ,ohne Inhomogenität der Abscheidung in der Längsrichtung der ICP-Quelle 120 zu erzeugen. Etwaige Konzentrationsgradienten entlang des weiteren Gasrohres 142 werden innerhalb der Abschirmung 158 homogenisiert, so dass am Gasaustrittsspalt 159 oder den Öffnungen 159 Längsrichtung der ICP-Quelle 120 eine homogene Stromdichte des austretenden Precursorgases generiert werden kann.

Die ICP-Quelle 120 kann sowohl für dynamische als auch für statische Beschichtungsanlagen, aber auch für andere Behandlungsanlagen verwendet werden.

## Patentansprüche

1. Behandlungsanlage, aufweisend:
eine Prozesskammer (101) zur Behandlung wenigstens eines Substrats und
eine induktiv gekoppelte Plasmaquelle, ICP-Quelle (120, 120'), mit einer Längsrichtung, wobei die ICP-Quelle (120, 120') aufweist:
wenigstens einen Induktor (130; 130a, 130b; 130a, 130b, 130c), der sich entlang der Längsrichtung der ICP-Quelle (120, 120') erstreckt,
eine Gaszuführeinrichtung (141, 142) für ein oder mehrere Prozessgase mit wenigstens einer Auslassöffnung, die konfiguriert ist, an mehreren Positionen entlang der Längsrichtung der ICP-Quelle (120, 120') das Prozessgas oder die Prozessgase zuzuführen, und
eine in der Prozesskammer (101) angeordnete Gaslenkanordnung (150), die sich entlang der Längsrichtung der ICP-Quelle (120, 120') erstreckt und den wenigstens einen Induktor (130; 130a, 130b; 130a, 130b, 130c) teilweise umgibt, wobei die Gaslenkanordnung (150) eine den wenigstens einen Induktor (130; 130a, 130b; 130a, 130b, 130c) und die wenigstens eine Auslassöffnung der Gaszuführeinrichtung (141) überdeckende Gashaube (151) aufweist, wobei die Gaslenkanordnung (150) eine Höhe H in einer Mittelebene der Gaslenkanordnung (150) und einen Auslass (152) mit einer Breite B₁ senkrecht zur Längsrichtung der ICP-Quelle (120, 120') aufweist und wobei ein Verhältnis der Breite B₁ des Auslasses (152) zur Höhe H der Gaslenkanordnung (150), B₁/H, kleiner als 1,0 ist.

2. Behandlungsanlage nach Anspruch 1, wobei die Gashaube (151) einen Auslass (152) aufweist, dessen Breite B₁ senkrecht zur Längsrichtung der ICP-Quelle (120, 120') maximal 300 mm, insbesondere maximal 200 mm, insbesondere maximal 150 mm, insbesondere maximal 130 mm ist, wobei die Gashaube (151) bevorzugt an ihrer vom Auslass (152) fernen Oberseite eine weitere Breite B₂ senkrecht zur Längsrichtung der ICP-Quelle (120, 120') aufweist, die kleiner als die Breite B₁ des Auslasses (152) ist, wobei die Gashaube (151) bevorzugt eine in Höhenrichtung (119) der Gashaube (151) abnehmende lichte Weite aufweist.

3. Behandlungsanlage nach einem der Ansprüche 1 bis 2, wobei die Gaszuführeinrichtung (141, 142) wenigstens ein Gaszuführrohr (141, 142) aufweist, das sich parallel zu dem wenigstens einen Induktor (130; 130a, 130b; 130a, 130b, 130c) in der Gashaube (151) entlang der Längsrichtung der ICP-Quelle (120, 120') erstreckt.

4. Behandlungsanlage nach einem der vorhergehenden Ansprüche, wobei die Auslassöffnung der Gaszuführeinrichtung (141, 142) und der wenigstens eine Induktor (130; 130a, 130b; 130a, 130b, 130c) entlang einer Mittelebene (160) der Gaszuführeinrichtung (141, 142) voneinander beabstandet sind, wobei bevorzugt die Auslassöffnung eines Gaszuführrohres (141) oberhalb des wenigstens einen Induktors (130; 130a, 130b; 130a, 130b, 130c) positioniert ist.

5. Behandlungsanlage nach einem der vorhergehenden Ansprüche, wobei der wenigstens eine Induktor (130; 130a, 130b; 130a, 130b, 130c) einen ersten Induktor (130a) und einen zweiten Induktor (130b, 130c) aufweist, wobei der erste Induktor (130a) mit dem zweiten Induktor (130b) elektrisch in Reihe verschaltet ist oder wobei der erste Induktor (130a) mit dem zweiten Induktor (130b) elektrisch parallel verschaltet ist, wobei der erste Induktor (130a) und der zweite Induktor (130b) bevorzugt in einer Mittelebene (160) der Gaslenkanordnung (150) angeordnet sind.

6. Behandlungsanlage nach einem der vorhergehenden Ansprüche, wobei die ICP-Quelle (120, 120') einen Generator (106) aufweist, der mit dem wenigstens einen Induktor (130; 130a, 130b; 130a, 130b, 130c) gekoppelt ist, wobei der Generator (106) konfiguriert ist, elektrische Wellen mit einer Wellenlänge von wenigstens 5 m, bevorzugt von wenigstens 10 m in dem wenigstens einen Induktor (130; 130a, 130b; 130a, 130b, 130c) zu erzeugen.

7. Behandlungsanlage nach einem der vorhergehenden Ansprüche, wobei die ICP-Quelle (120, 120') für einen Betrieb bei einem Druck in der Prozesskammer (101) im Bereich von 0,1 bis 1000 Pa, insbesondere von 0,1 bis 500 Pa, insbesondere von 0,1 Pa bis 250 Pa, insbesondere von 0,1 Pa bis 200 Pa, insbesondere von 1 Pa bis 100 Pa, insbesondere von 10 Pa bis 100 Pa konfiguriert ist.

8. Behandlungsanlage nach einem der vorhergehenden Ansprüche, ferner aufweisend einen Gasverteiler (142) für wenigstens ein Prozessgas, wobei die Gaslenkanordnung (150) eine Abschirmung (158) für den Gasverteiler (142) aufweist.

9. Behandlungsanlage nach Anspruch 8, wobei die Abschirmung (158) einen sich in der Längsrichtung der ICP-Quelle (120, 120') entlang der Gaslenkanordnung (150) erstreckenden Auslassschlitz (159) oder eine Reihe von entlang der Längsrichtung der ICP-Quelle (120, 120') angeordneten Durchlässen (159) aufweist, wobei der Auslassschlitz (159) oder die Durchlässe (159) bevorzugt eine Weite von maximal 40 mm, insbesondere von maximal 25 mm, insbesondere von maximal 10 mm aufweist/aufweisen.

10. Behandlungsanlage nach einem der Ansprüche 8 bis 9, wobei der Gasverteiler (142) mehrere Auslassöffnungen mit einem Auslassöffnungsdurchmesser aufweist, wobei ein Verhältnis des Auslassöffnungsdurchmessers zu einem Durchmesser des Gasverteilers (142) höchstens 0,5, insbesondere höchstens 0,1 ist.

11. Behandlungsanlage nach einem der vorhergehenden Ansprüche, wobei der wenigstens eine Induktor (130; 130a, 130b; 130a, 130b, 130c) eine Länge von wenigstens 1.000 mm, insbesondere von wenigstens 1.200 mm, insbesondere von wenigstens 1.400 mm entlang der Längsrichtung der ICP-Quelle (120, 120') aufweist.

12. Behandlungsanlage nach einem der vorhergehenden Ansprüche, wobei der wenigstens eine Induktor (130; 130a, 130b; 130a, 130b, 130c) eine entlang der Längsrichtung der ICP-Quelle (120, 120') veränderliche Impedanz aufweist, wobei der wenigstens eine Induktor (130; 130a, 130b; 130a, 130b, 130c) einen gestuften Innenleiter, der entlang der Längsrichtung der ICP-Quelle (120, 120') eine Veränderung eines Leiterrohrradius aufweist, und/oder eine entlang der Längsrichtung der ICP-Quelle (120, 120') veränderliche Isolationsdicke aufweist.

13. Behandlungsanlage nach einem der vorhergehenden Ansprüche, wobei die Behandlungsanlage konfiguriert ist, ein Beschichtungsverfahren, ein chemisches oder physikalisches Ätzverfahren auszuführen und/oder eine Oberfläche des wenigstens einen Substrats zu oxidieren, und/oder wobei die Behandlungsanlage zur Erzeugung von Oxiden, Nitriden und/oder Oxinitriden konfiguriert ist und/oder wobei die Behandlungsanlage zur Funktionalisierung von Oberflächen konfiguriert ist und/oder wobei die Behandlungsanlage konfiguriert ist, ein Reinigungsverfahren auszuführen.

14. Plasmabehandlungsverfahren zur Behandlung von Substraten mit einer Behandlungsanlage (100), aufweisend die Schritte:
Positionieren wenigstens eines Substrats in einer Prozesskammer (101) der Behandlungsanlage (100),
Anregen eines induktiv gekoppelten Plasmas, ICPs, unter Verwendung einer ICP-Quelle (120, 120'), die wenigstens einen Induktor (130; 130a, 130b; 130a, 130b, 130c), der sich entlang der Längsrichtung der ICP-Quelle (120, 120') erstreckt, eine Gaszuführeinrichtung (141, 142) und eine in der Prozesskammer (101) angeordnete Gaslenkanordnung (150) aufweist, die sich entlang einer Längsrichtung der ICP-Quelle (120, 120') erstreckt und den wenigstens einen Induktor (130; 130a, 130b; 130a, 130b, 130c) teilweise umgibt, wobei die Gaslenkanordnung (150) eine den wenigstens einen Induktor (130; 130a, 130b; 130a, 130b, 130c) und die wenigstens eine Auslassöffnung der Gaszuführeinrichtung (141) überdeckende Gashaube (151) aufweist, wobei die Gaslenkanordnung (150) eine Höhe H in einer Mittelebene der Gaslenkanordnung (150) und einen Auslass (152) mit einer Breite B₁ senkrecht zur Längsrichtung der ICP-Quelle (120, 120') aufweist und wobei ein Verhältnis der Breite B₁ des Auslasses (152) zur Höhe H der Gaslenkanordnung (150), B₁/H, kleiner als 1,0 ist; und
Zuführen von einem Prozessgas oder mehreren Prozessgasen mit der Gaszuführeinrichtung (141, 142) an mehreren Positionen entlang der Längsrichtung der ICP-Quelle (120, 120').

15. Plasmabehandlungsverfahren nach Anspruch 14, wobei eine dynamische Schichtabscheidung mit einer Rate erfolgt, die
für eine Abscheidung von SiNx wenigstens 70 nm · m/min beträgt oder
für eine Abscheidung von AlOx wenigstens 8 nm · m/min beträgt, und/oder
wobei eine Schichtabscheidung mit einer Abweichung von weniger als ± 3%, insbesondere von weniger als ± 2% entlang der Längsrichtung der ICP-Quelle (120, 120') erfolgt.

## Claims

1. Treatment system comprising:
a process chamber (101) for treating at least one substrate, and
an inductively coupled plasma source, ICP source (120, 120'), with a longitudinal direction, wherein the ICP source (120, 120') comprises:
at least one inductor (130; 130a, 130b; 130a, 130b, 130c) extending along the longitudinal direction of the ICP source (120, 120'),
a gas supply device (141, 142) for one or more process gases with at least one outlet opening configured to supply the process gas or process gases at multiple positions along the longitudinal direction of the ICP source (120, 120'), and
a gas steering arrangement (150) arranged in the process chamber (101), which extends along the longitudinal direction of the ICP source (120, 120') and partially surrounds at least one inductor (130; 130a, 130b; 130a, 130b, 130c),
wherein the gas steering arrangement (150) comprises a gas hood (151) covering the at least one inductor (130; 130a, 130b; 130a, 130b, 130c) and the at least one gas outlet opening of the gas supply device (141), wherein the gas steering arrangement (150) has a height H in a central plane of the gas steering arrangement (150) and an outlet (152) with a width B₁ perpendicular to the longitudinal direction of the ICP source (120, 120') and wherein a ratio of the width B₁ of the outlet (152) to the height H of the gas steering arrangement (150), B₁/H, is smaller than 1.0.

2. Treatment system according to claim 1, wherein the gas hood (151) has an outlet (152) whose width B₁ perpendicular to the longitudinal direction of the ICP source (120, 120') is at most 300 mm, in particular at most 200 mm, in particular at most 150 mm, in particular at most 130 mm, wherein the gas hood (151) preferably has a further width B₂, perpendicular to the longitudinal direction of the ICP source (120, 120'), on its top side remote from the outlet (152), which is smaller than the width B₁ of the outlet (152), wherein the gas hood (151) preferably has a clear width that decreases in the height direction (119) of the gas hood (151).

3. Treatment system according to any one of claims 1 to 2, wherein the gas supply device (141, 142) has at least one gas supply tube (141, 142) which extends parallel to the at least one inductor (130; 130a, 130b; 130a, 130b, 130c) in the gas hood (151) along the longitudinal direction of the ICP source (120, 120').

4. Treatment system according to any one of the preceding claims, wherein the outlet opening of the gas supply device (141, 142) and the at least one inductor (130; 130a, 130b; 130a, 130b, 130c) are spaced apart from each other along a central plane (160) of the gas supply device (141, 142), wherein the outlet opening of a gas supply tube (141) is preferably positioned above the at least one inductor (130; 130a, 130b; 130a, 130b, 130c).

5. Treatment system according to any one of the preceding claims, wherein the at least one inductor (130; 130a, 130b; 130a, 130b, 130c) comprises a first inductor (130a) and a second inductor (130b, 130c), wherein the first inductor (130a) is electrically connected in series with the second inductor (130b), or wherein the first inductor (130a) is electrically connected in parallel with the second inductor (130b), wherein the first inductor (130a) and the second inductor (130b) are preferably arranged in a central plane (160) of the gas steering arrangement (150).

6. Treatment system according to any one of the preceding claims, wherein the ICP source (120, 120') comprises a generator (106) coupled to the at least one inductor (130; 130a, 130b; 130a, 130b, 130c), wherein the generator (106) is configured to generate electric waves with a wavelength of at least 5 m, preferably at least 10 m, in the at least one inductor (130; 130a, 130b; 130a, 130b, 130c).

7. Treatment system according to any one of the preceding claims, wherein the ICP source (120, 120') is configured for operation at a pressure in the process chamber (101) in the range from 0.1 to 1000 Pa, in particular from 0.1 to 500 Pa, in particular from 0.1 Pa to 250 Pa, in particular from 0.1 Pa to 200 Pa, in particular from 1 Pa to 100 Pa, in particular from 10 Pa to 100 Pa.

8. Treatment system according to any one of the preceding claims, further comprising a gas distributor (142) for at least one process gas, wherein the gas steering arrangement (150) comprises a shield (158) for the gas distributor (142).

9. Treatment system according to claim 8, wherein the shield (158) has an outlet slot (159) extending in the longitudinal direction of the ICP source (120, 120') along the gas steering arrangement (150) or a plurality of outlet openings (159) disposed along the longitudinal direction of the ICP source (120, 120'), wherein the outlet slot (159) or the outlet openings (159) preferably have a width of at most 40 mm, in particular at most 25 mm, in particular of at most 10 mm.

10. Treatment system according to any one of claims 8 to 9, wherein the gas distributor (142) has a plurality of outlet openings with an outlet opening diameter, wherein a ratio of the outlet opening diameter to a diameter of the gas distributor (142) is at most 0.5, in particular at most 0.1.

11. Treatment system according to any one of the preceding claims, wherein the at least one inductor (130; 130a, 130b; 130a, 130b, 130c) has a length of at least 1,000 mm, in particular at least 1,200 mm, in particular at least 1,400 mm along the longitudinal direction of the ICP source (120, 120').

12. Treatment system according to any one of the preceding claims, wherein the at least one inductor (130; 130a, 130b; 130a, 130b, 130c) has an impedance that varies along the longitudinal direction of the ICP source (120, 120'), wherein the at least one inductor (130; 130a, 130b; 130a, 130b, 130c) has a stepped inner conductor presenting a change in conductor tube radius along the longitudinal direction of the ICP source (120, 120') and/or a variable insulation thickness along the longitudinal direction of the ICP source (120, 120').

13. Treatment system according to any one of the preceding claims, wherein the treatment system is configured to perform a coating process, a chemical or physical etching process and/or to oxidize a surface of the at least one substrate and/or wherein the treatment system is configured to generate oxides, nitrides, and/or oxynitrides and/or wherein the treatment system is configured to functionalize surfaces and/or wherein the treatment system is configured to perform a cleaning process.

14. Plasma treatment method for treating substrates with a treatment system (100), comprising the steps of:
positioning at least one substrate in a process chamber (101) of the treatment system (100),
exciting an inductively coupled plasma, ICP, using an ICP source (120, 120') comprising at least one inductor (130; 130a, 130b; 130a, 130b, 130c) which extends along the longitudinal direction of the ICP source (120, 120'), a gas supply device (141, 142) and a gas steering arrangement (150) arranged in the process chamber (101), which extends along a longitudinal direction of the ICP source (120, 120') and partially surrounds the at least one inductor (130; 130a, 130b; 130a, 130b, 130c), wherein gas steering arrangement (150) comprises a gas hood (151) covering the at least one inductor (130; 130a, 130b; 130a, 130b, 130c) and the at least one outlet opening of the gas supply device (141), wherein the gas steering arrangement (150) has a height H in a central plane of the gas steering arrangement (150) and an outlet (152) with a width B₁ perpendicular to the longitudinal direction of the ICP source (120, 120') and wherein a ratio of the width B₁ of the outlet (152) to the height H of the gas directing arrangement (150), B₁/H, is smaller than 1.0 and
suppling a process gas or several process gases with the gas supply device (141, 142) at multiple positions along the longitudinal direction of the ICP source (120, 120').

15. Plasma treatment method according to claim 14, wherein a dynamic layer deposition takes place at a rate
that is at least 70 nm · m/min for SiNx deposition, or
that is at least 8 nm · m/min for AlOx deposition, and/or
wherein a layer deposition takes place with a deviation of less than ± 3%, in particular less than ± 2% along the longitudinal direction of the ICP source (120, 120').

## Revendications

1. Appareil de traitement, comportant :
une chambre de processus (101) pour le traitement d'au moins un substrat et
une source de plasma à couplage inductif, source d'ICP (120, 120'), ayant une direction longitudinale, la source d'ICP (120, 120') présentant :
au moins un inducteur (130 ; 130a, 130b ; 130a, 130b, 130c) qui s'étend le long de la direction longitudinale de la source d'ICP (120, 120'),
un système d'amenée de gaz (141, 142) pour un ou plusieurs gaz de processus ayant au moins une ouverture d'échappement conçue pour amener le gaz de processus ou les gaz de processus en plusieurs emplacements le long de la direction longitudinale de la source d'ICP (120, 120'), et
un ensemble d'orientation de gaz (150) disposé dans la chambre de processus (101) qui s'étend le long de la direction longitudinale de la source d'ICP (120, 120') et qui entoure partiellement le au moins un inducteur (130 ; 130a, 130b ; 130a, 130b, 130c), dans lequel l'ensemble d'orientation de gaz (150) présente une hotte de gaz (151) recouvrant le au moins un inducteur (130 ; 130a, 130b ; 130a, 130b, 130c) et la au moins une ouverture d'échappement du système d'amenée de gaz (141), dans lequel l'ensemble d'orientation de gaz (150) présente une hauteur H dans un plan médian de l'ensemble d'orientation de gaz (150) et un échappement (152) ayant une largeur B₁ perpendiculaire à la direction longitudinale de la source d'ICP (120, 120') et dans lequel un rapport de la largeur B₁ de l'échappement (152) sur la hauteur H de l'ensemble d'orientation de gaz (150), B₁/H, est inférieur à 1,0.

2. Appareil de traitement selon la revendication 1, dans lequel la hotte de gaz (151) présente un échappement (152) dont la largeur B₁ perpendiculairement à la direction longitudinale de la source d'ICP (120, 120') est au maximum de 300 mm, notamment au maximum de 200 mm, en particulier au maximum de 150 mm, particulièrement au maximum de 130 mm, dans lequel la hotte de gaz (151) présente de préférence sur sa face supérieure éloignée de l'échappement (152) une autre largeur B₂ perpendiculairement à la direction longitudinale de la source d'ICP (120, 120'), qui est inférieure à la largeur B₁ de l'échappement (152), dans lequel la hotte de gaz (151) présente de préférence un diamètre intérieur diminuant dans la direction de la hauteur (119) de la hotte de gaz (151).

3. Appareil de traitement selon l'une des revendications 1 à 2, dans lequel le système d'amenée de gaz (141, 142) présente au moins une conduite d'amenée de gaz (141, 142), qui s'étend parallèlement au au moins un inducteur (130 ; 130a, 130b ; 130a, 130b, 130c) dans la hotte de gaz (151) le long de la direction longitudinale de la source d'ICP (120, 120').

4. Appareil de traitement selon l'une des revendications précédentes, dans lequel l'ouverture d'échappement du système d'amenée de gaz (141, 142) et le au moins un inducteur (130 ; 130a, 130b ; 130a, 130b, 130c) sont distants l'une de l'autre le long d'un plan médian (160) du système d'amenée de gaz (141, 142), dans lequel l'ouverture d'échappement d'une conduite d'amenée de gaz (141) est de préférence placée au-dessus du au moins un inducteur (130 ; 130a, 130b ; 130a, 130b, 130c).

5. Appareil de traitement selon l'une des revendications précédentes, dans lequel le au moins un inducteur (130 ; 130a, 130b ; 130a, 130b, 130c) présente un premier inducteur (130a) et un deuxième inducteur (130b, 130c), dans lequel le premier inducteur (130a) est monté électriquement en série avec le deuxième inducteur (130b) ou le premier inducteur (130a) est monté électriquement en parallèle avec le deuxième inducteur (130b), le premier inducteur (130a) et le deuxième inducteur (130b) étant disposés de préférence dans un plan médian (160) de l'ensemble d'orientation de gaz (150).

6. Appareil de traitement selon l'une des revendications précédentes, dans lequel la source d'ICP (120, 120') présente un générateur (106) qui est couplé au au moins un inducteur (130 ; 130a, 130b ; 130a, 130b, 130c), le générateur (106) étant conçu pour produire des ondes électriques ayant une longueur d'ondes d'au moins 5 m, de préférence d'au moins 10 m dans le au moins un inducteur (130 ; 130a, 130b ; 130a, 130b, 130c).

7. Appareil de traitement selon l'une des revendications précédentes, dans lequel la source d'ICP (120, 120') est conçue pour une exploitation à une pression dans la chambre de traitement (101) dans la zone de 0,1 à 1000 Pa, en particulier de 0,1 à 500 Pa, en particulier de 0,1 Pa à 250 Pa, en particulier de 0,1 Pa à 200 Pa, en particulier de 1 Pa à 100 Pa, en particulier de 10 Pa à 100 Pa.

8. Appareil de traitement selon l'une des revendications précédentes, comportant en outre un répartiteur de gaz (142) pour au moins un gaz de processus, dans lequel l'ensemble d'orientation de gaz (150) présente un blindage (158) pour le répartiteur de gaz (142).

9. Appareil de traitement selon la revendication 8, dans lequel le blindage (158) présente une fente d'échappement (159) s'étendant dans la direction longitudinale de la source d'ICP (120, 120') le long de l'ensemble d'orientation de gaz (150) ou une pluralité de passages (159) disposés le long de la direction longitudinale de la source d'ICP (120, 120'), la fente d'échappement (159) ou les passages (159) présentant de préférence une largeur d'au maximum 40 mm, en particulier d'au maximum 25 mm, en particulier d'au maximum 10 mm.

10. Appareil de traitement selon l'une des revendications 8 à 9, dans lequel le répartiteur de gaz (142) présente plusieurs ouvertures d'échappement ayant un diamètre d'ouverture d'échappement, un rapport du diamètre d'ouverture d'échappement sur un diamètre du répartiteur de gaz (142) étant au maximum de 0,5, en particulier d'au maximum 0,1.

11. Appareil de traitement selon l'une des revendications précédentes, dans lequel le au moins un inducteur (130 ; 130a, 130b ; 130a, 130b, 130c) présente une longueur d'au moins 1000 mm, en particulier d'au moins 1200 mm, en particulier d'au moins 1400 mm le long de la direction longitudinale de la source d'ICP (120, 120').

12. Appareil de traitement selon l'une des revendications précédentes, dans lequel le au moins un inducteur (130 ; 130a, 130b ; 130a, 130b, 130c) présente une impédance variable le long de la direction longitudinale de la source d'ICP (120, 120'), dans lequel le au moins un inducteur (130 ; 130a, 130b ; 130a, 130b, 130c) présente un conducteur interne étagé, qui présente le long de la direction longitudinale de la source d'ICP (120, 120') une variation du rayon du tube du conducteur et/ou une épaisseur d'isolation variable le long de la direction longitudinale de la source d'ICP (120, 120').

13. Appareil de traitement selon l'une des revendications précédentes, dans lequel l'appareil de traitement est conçu pour exécuter un procédé de revêtement, un procédé de gravure chimique ou physique et/ou oxyder une surface du au moins un substrat, et/ou dans lequel l'appareil de traitement est conçu pour produire des oxydes, des nitrures et/ou des oxynitrures et/ou dans lequel l'appareil de traitement est conçu pour fonctionnaliser des surfaces et/ou dans lequel l'appareil de traitement est conçu pour exécuter un procédé de nettoyage.

14. Procédé de traitement au plasma pour le traitement de substrats avec un appareil de traitement (100), présentant les étapes de :
placement d'au moins un substrat dans une chambre de processus (101) de l'appareil de traitement (100),
excitation d'un plasma à couplage inductif, ICP, en utilisant une source d'ICP (120, 120') qui présente au moins un inducteur (130 ; 130a, 130b ; 130a, 130b, 130c) qui s'étend le long de la direction longitudinale de la source d'ICP (120, 120'), un système d'amenée de gaz (141, 142) et un ensemble d'orientation de gaz (150) disposé dans la chambre de processus (101), qui s'étend le long de la direction longitudinale de la source d'ICP (120, 120') et qui entoure partiellement le au moins un inducteur (130 ; 130a, 130b ; 130a, 130b, 130c), dans lequel l'ensemble d'orientation de gaz (150) présente une hotte de gaz (151) recouvrant le au moins un inducteur (130 ; 130a, 130b ; 130a, 130b, 130c) et la au moins une ouverture d'échappement du système d'amenée de gaz (141), dans lequel l'ensemble d'orientation de gaz (150) présente une hauteur H dans un plan médian de l'ensemble d'orientation de gaz (150) et un échappement (152) ayant une largeur B₁ perpendiculaire à la direction longitudinale de la source d'ICP (120, 120') et dans lequel un rapport de la largeur B₁ de l'échappement (152) sur la hauteur H de l'ensemble d'orientation de gaz (150), B₁/H, est inférieur à 1,0 ; et
amenée d'un gaz de processus ou de plusieurs gaz de processus avec un système d'amenée de gaz (141, 142) en plusieurs emplacements le long de la direction longitudinale de la source d'ICP (120, 120').

15. Procédé de traitement au plasma selon la revendication 14, dans lequel un dépôt de couche dynamique s'effectue avec une vitesse qui
est d'au moins 70 nm · m/min pour un dépôt de SiNx ou
est d'au moins 8 nm · m/min pour un dépôt d'AlOx, et/ou
dans lequel le dépôt de couche s'effectue avec une tolérance inférieure à ± 3 %, en particulier inférieure à ± 2 % le long de la direction longitudinale de la source d'ICP (120, 120').
